# EUROPÄISCHE PATENTSCHRIFT

(11) **EP 2 649 295 B1**
(45) Veröffentlichungstag und Bekanntmachung des Hinweises auf die Patenterteilung: **16.09.2015**
(21) Anmeldenummer: 11776794.7
(22) Anmeldetag: 31.10.2011
(51) Int. Cl.: F02M 51/00, F02M 51/06, F02M 61/16, F02M 63/00, H01L 41/053

(54) **PIEZOELEKTRISCHES AKTORMODUL UND BRENNSTOFFEINSPRITZVENTIL**
PIEZOELECTRIC ACTUATOR MODULE AND FUEL INJECTION VALVE
MODULE D'ACTIONNEUR PIÉZOÉLECTRIQUE ET SOUPAPE D'INJECTION DE CARBURANT

(30) Priorität: 07.12.2010 DE 102010062518
(43) Veröffentlichungstag der Anmeldung: 16.10.2013
(73) Patentinhaber: Robert Bosch GmbH, 70442 Stuttgart (DE)
(72) Erfinder: KOPF, Matthias, 71254 Ditzingen (DE)
(86) Internationale Anmeldenummer: PCT/EP2011/069111
(87) Internationale Veröffentlichungsnummer: WO 2012/076255

(56) Entgegenhaltungen:
- EP-A1- 2 224 123
- DE-A1- 19 538 791
- DE-A1-102008 044 164
- US-A- 5 239 223
- US-A- 5 477 102

## Beschreibung

### Stand der Technik

Die Erfindung betrifft ein piezoelektrisches Aktormodul und ein Brennstoffeinspritzventil. Speziell betrifft die Erfindung das Gebiet der Injektoren für Brennstoffeinspritzanlagen für luftverdichtende, selbstzündende Brennkraftmaschinen (DE-A-102008044164).

Bei der Ausgestaltung eines piezoelektrischen Aktormoduls ist es denkbar, dass eine elektrische Kontaktierung eines Piezoaktors des Aktormoduls über einen kunststoffummantelten Kupferdraht erfolgt, der durch ein als Aktorfuß dienendes Stahlteil geführt ist. Über eine geeignete Dichtbuchse kann hierbei die Abdichtung nach außen gewährleistet werden. Problematisch ist hierbei allerdings die Positionierung des Piezoaktors relativ zu dem Aktorfuß, da durch Relativbewegungen eine Belastung des Kupferdrahtes auftreten kann, die über die Lebensdauer die elektrische Kontaktierung beeinträchtigt. Im Extremfall kann der Kupferdraht von einer Außenelektrode abreißen.

### Offenbarung der Erfindung

Das erfindungsgemäß piezoelektrische Aktormodul mit den Merkmalen des Anspruchs 1 und das erfindungsgemäße Brennstoffeinspritzventil mit den Merkmalen des Anspruchs 8 haben den Vorteil, dass ein verbesserter Aufbau ermöglicht ist und insbesondere eine verbesserte Anordnung des Aktorkörpers an dem Übergangsstück ermöglicht ist. Speziell besteht der Vorteil, dass eine zuverlässige Positionierung des Aktorkörpers relativ zu dem Übergangsstück erzielt ist und zugleich eine zuverlässige elektrische Kontaktierung über die Lebensdauer ermöglicht ist.

Durch die in den Unteransprüchen aufgeführten Maßnahmen sind vorteilhafte Weiterbildungen des im Anspruch 1 angegebenen piezoelektrischen Aktormoduls möglich. Das Übergangsstück umfasst einen metallischen Grundkörper, wobei die Einfassung an den metallischen Grundkörper angespritzt ist. Speziell kann das Übergangsstück als Aktorfuß ausgestaltet sein, wobei elektrische Zuleitungen durch den Aktorfuß geführt sind. Die Einfassung ist Teil einer Umspritzung des Grundkörpers. Hierbei kann diese Umspritzung die elektrische Zuleitung für den Aktorkörper in vorteilhafter Weise in ihrer Position fixieren. Möglich ist es auch, dass ein weiteres Übergangsstück vorgesehen ist, so dass der Aktorkörper an seinen beiden Enden jeweils in ein Übergangsstück eingesetzt ist. Hierbei kann das weitere Übergangsstück entsprechend dem Übergangsstück ausgestaltet sein. Insbesondere können somit ein Aktorfuß, durch den die elektrischen Zuleitungen geführt sind, und ein Aktorkopf in vorteilhafter Weise ausgestaltet und zuverlässig an dem Aktorkörper angebracht werden. Hierdurch sind die einzelnen Bauteile des Aktormoduls zuverlässig zusammen montierbar und im montierten Zustand zueinander positioniert. Unerwünschte Relativbewegungen der einzelnen Bauteile des Aktormoduls sind hierbei über die Lebensdauer verhindert.

Die Einfassung weist einen Randsteg auf, der sich zumindest abschnittsweise um die Anlagefläche, an der der Aktorkörper mit seiner Stirnseite anliegt, erstreckt. Hierbei ist es ferner vorteilhaft, dass der Aktorkörper mit seinem Ende in den Randsteg der Einfassung eingefügt ist. Die Größe der Auflagefläche des Übergangsstücks ist hierbei zumindest näherungsweise gleich groß wie eine Größe der Stirnseite des Aktorkörpers. Daher kann der Aktorkörper durch den Randsteg zuverlässig positioniert werden. Insbesondere ist eine mittige Positionierung des Aktorkörpers in Bezug auf das Übergangsstück möglich. Durch den Randsteg kann hierbei allseitig eine Einfassung des Aktorkörpers erreicht werden, so dass ein Verschieben des Aktorkörpers mit seiner Stirnseite auf der Anlagefläche verhindert ist. Eine separate Ausrichtung des Aktorkörpers an einer Längsachse bei der Montage des Aktormoduls kann somit eingespart werden.

Aktorkörper weist an einer Außenseite eine Außenelektrode auf.

Es ist Vorteilhaft, das der Aktorkörper zwischen der Außenelektrode und der Stirnseite am Ende des Aktorkörpers einen passiven Bereich aufweist und dass der Randsteg der Einfassung den Aktorkörper an seinem passiven Bereich umgreift. Hierbei kann der Randsteg an dem passiven Bereich des Aktorkörpers zumindest teilweise anliegen. Allerdings erfolgt keine Anlage an einem aktiven Bereich des Aktorkörpers, in dem Innenelektrodenschichten des Aktorkörpers vorgesehen sind. Da im passiven Bereich des Aktorkörpers keine Längenänderung, insbesondere Längenausdehnung, des Aktorkörpers erfolgt, wird eine Reibung zwischen der Einfassung und dem Aktorkörper von vornherein verhindert. Hierdurch werden auch Abnutzungen an der Außenseite des Aktorkörpers, die gegebenenfalls zu elektrischen Überschlägen zwischen den Innenelektroden führen könnten, verhindert. Somit kann die Funktionsfähigkeit über die Lebenszeit gewährleistet werden. Außerdem wird eine zuverlässige Wärmeabfuhr von dem sich erwärmenden aktiven Bereich des Aktorkörpers an die Umgebung ermöglicht, die nicht durch die vorzugsweise aus Kunststoff bestehende Einfassung behindert wird, da sich die Einfassung im passiven Bereich des Aktorkörpers befindet.

Vorteilhaft ist es auch, dass entlang einer Längsachse des Aktorkörpers eine Höhe des Randstegs der Einfassung nicht größer ist als eine Höhe des passiven Bereichs des Aktorkörpers. Speziell ist es vorteilhaft, dass der aktive Bereich des Aktorkörpers in Bezug auf den passiven Bereich sehr groß ist. Somit ergibt sich in Bezug auf die Baugröße ein großes Dehnungsvermögen. Die Einfassung des entsprechend kleinen passiven Bereichs kann auch durch eine geringe Höhe des Randstegs der Einfassung gewährleistet werden. Weitere Elemente der Einfassung können sich in einem gewissen Abstand zu den Außenseiten des Aktorkörpers über den Randsteg der Einfassung hinaus erheben. Somit wird auch bei einer geringen Höhe des passiven Bereichs eine zuverlässige Positionierung des Aktorkörpers an dem Übergangsstück gewährleistet. Hierbei kann ein Abriss der elektrischen Zuleitung von einer Außenelektrode über die Lebenszeit verhindert werden. Außerdem werden Montageungenauigkeiten von vornherein verhindert, da die gewünschte Montagetoleranz vorgegeben ist.

Der Randsteg der Einfassung des Übergangsstücks weist zumindest eine Ausnehmung auf, an der ein elektrischer Kontakt aus der Einfassung geführt ist und der elektrische Kontakt ist mit einer Außenelektrode des Aktorkörpers verbunden. Der elektrische Kontakt kann hierbei Teil der elektrischen Zuleitung sein und an einer geeigneten Stelle aus der aus Kunststoff gebildeten Einfassung geführt sein. Somit ist im Bereich der Einfassung auch eine elektrische Isolierung des elektrischen Kontakts zu einem beispielsweise aus Stahl bestehenden Grundkörper des Übergangsstücks gewährleistet. Beispielsweise kann der elektrische Kontakt in die Einfassung eingespritzt sein. Somit ist der elektrische Kontakt zuverlässig bezüglich des von der Einfassung gehaltenen Aktorkörpers positioniert. Eine Relativbewegung im Betrieb zwischen dem elektrischen Kontakt und der Außenelektrode des Aktorkörpers ist hierdurch von vornherein verhindert. Eine Beeinträchtigung der elektrischen Verbindung, insbesondere ein Abreißen des elektrischen Kontakts von der Außenelektrode, wird somit verhindert.

### Kurze Beschreibung der Zeichnungen

Bevorzugte Ausführungsbeispiele der Erfindung sind in der nachfolgenden Beschreibung anhand der beigefügten Zeichnungen, in denen sich entsprechende Elemente mit übereinstimmenden Bezugszeichen versehen sind, näher erläutert. Es zeigt:
Fig. 1 ein Brennstoffeinspritzventil mit einem piezoelektrischen Aktormodul in einer auszugsweisen, schematischen Darstellung entsprechend einem Ausführungsbeispiel der Erfindung und
Fig. 2 ein Übergangsstück des in Fig. 1 dargestellten piezoelektrischen Aktormoduls des Brennstoffeinspritzventils des Ausführungsbeispiels der Erfindung in einer schematischen, räumlichen Darstellung.

### Ausführungsformen der Erfindung

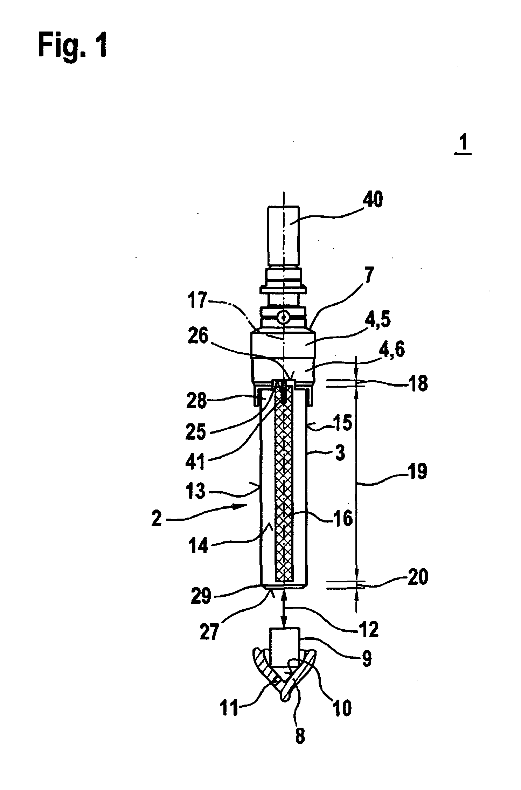

Fig. 1 zeigt ein Brennstoffeinspritzventil 1 mit einem piezoelektrischen Aktormodul 2 in einer auszugsweisen, schematischen Darstellung entsprechend einem Ausführungsbeispiel der Erfindung. Das Brennstoffeinspritzventil 1 kann insbesondere als Injektor für luftverdichtende, selbstzündende Brennkraftmaschinen dienen. Das piezoelektrische Aktormodul 2 eignet sich besonders für solche Brennstoffeinspritzventile 1. Das erfindungsgemäße Brennstoffeinspritzventil 1 und das erfindungsgemäße piezoelektrische Aktormodul 2 eignen sich jedoch auch für andere Anwendungsfälle.

Das piezoelektrische Aktormodul 2 weist einen Aktorkörper 3 und ein Übergangsstück 4 auf. In diesem Ausführungsbeispiel ist das Übergangsstück 4 als Aktorfuß 4 ausgestaltet. Der Aktorfuß 4 weist einen Grundkörper 5 aus einem metallischen Werkstoff, insbesondere Edelstahl, auf. Ferner weist der Aktorfuß 4 eine Umspritzung 6 aus einem Kunststoff auf, die eine Einfassung 6 für den Aktorkörper 3 bildet. Die Umspritzung 6 ist hierbei an den Grundkörper 5 gespritzt. Der metallische Grundkörper 5 weist eine Fase 7 auf, mittels der das piezoelektrische Aktormodul 2 in einem Gehäuseteil (nicht dargestellt) des Brennstoffeinspritzventils 1 abgestützt werden kann.

Das Brennstoffeinspritzventil 1 weist außerdem einen Düsenkörper 8 auf, in dem eine Düsennadel 9 angeordnet ist. Die Düsennadel 9 wirkt hierbei mit einer an dem Düsenkörper 8 ausgestalteten Ventilsitzfläche 10 zu einem Ventilsitz zusammen. Der Düsenkörper 8 weist eine oder mehrere Düsenbohrungen 11 auf. Das piezoelektrische Aktormodul 2 dient zum direkten oder indirekten Betätigen der Düsennadel 9, wie es durch den Doppelpfeil 12 veranschaulicht ist. Bei einer Betätigung der Düsennadel 9 hebt diese von der Ventilsitzfläche 10 ab, so dass der Dichtsitz geöffnet wird und Brennstoff über den geöffneten Dichtsitz durch die Düsenbohrung 11 in den Brennraum einer Brennkraftmaschine oder dergleichen eingespritzt wird.

In diesem Ausführungsbeispiel weist der Aktorkörper 3 vier Außenseiten 13, 14, 15 auf, wobei eine der Außenseiten in der Darstellung verdeckt ist. Insbesondere kann der Aktorkörper 3 zumindest näherungsweise eine quaderförmige Ausgestaltung mit quadratischem Querschnitt aufweisen. Die Übergänge zwischen den Außenseiten 13 bis 15 können hierbei abgerundet ausgestaltet sein.

An der Außenseite 14 des Aktorkörpers 3 ist eine Außenelektrode 16 angebracht. Eine weitere Außenelektrode ist an die verdeckte Seite des Aktorkörpers 3, die von der Außenseite 14 abgewandt ist, angebracht. Die Außenelektrode 16 und die nicht dargestellte weitere Außenelektrode sind wechselweise mit den Elektrodenschichten des Aktorkörpers 3 verbunden. Hierbei sind die innenliegenden Elektrodenschichten jeweils zwischen piezokeramischen Schichten des Aktorkörpers 3 angeordnet. Der Aktorkörper 3 weist entlang einer Längsachse 17 drei Bereiche 18, 19, 20 auf. In dem Bereich 19 sind eine Vielzahl von Elektrodenschichten und eine Vielzahl von zwischen den Elektrodenschichten vorgesehenen keramischen Schichten vorgesehen. Der Bereich 19 ist dadurch der aktive Bereich 19 des Aktorkörpers 3. In den Bereichen 18,20 sind keine Elektrodenschichten vorgesehen. Die Bereiche 18, 20 sind hierbei aus keramischem Material gebildet. Somit sind die Bereiche 18, 20 passive Bereiche 18, 20 des Aktorkörpers 3. Im Betrieb des piezoelektrischen Aktormoduls 2 tritt das Dehnungsverhalten des Aktorkörpers 3 nur im aktiven Bereich 19 auf. Die passiven Bereiche 18, 20 behalten prinzipbedingt ihre konstante, entlang der Längsachse 17 gesehene Höhe 18 beziehungsweise Höhe 20 bei.

Die Außenelektrode 16 erstreckt sich nur über den aktiven Bereich 19 des Aktorkörpers 3. Die passiven Bereiche 18, 20 des Aktorkörpers 3 sind freigelassen.

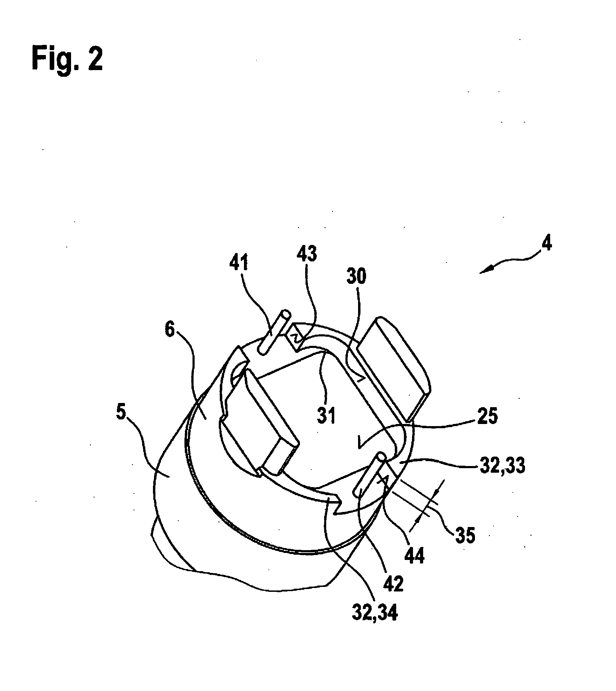

Die Ausgestaltung des piezoelektrischen Aktormoduls 2 des Brennstoffeinspritzventils 1 des Ausführungsbeispiels ist im Folgenden auch unter Bezugnahme auf die Fig. 2 beschrieben.

Fig. 2 zeigt das in Fig. 1 dargestellte Übergangsstück 4, das heißt den Aktorfuß 4, in einer räumlichen Darstellung. Der Aktorfuß 4 weist eine Anlagefläche 25 auf, die vorzugsweise an dem Grundkörper 5 des Aktorfußes 4 ausgestaltet ist. Hierdurch ist die Auflagefläche 25 an dem metallischen Werkstoff des Grundkörpers 5 ausgebildet. Hierdurch ist eine vorteilhafte Kraftübertragung von dem Aktorkörper 3 auf den Aktorfuß 4 zur Abstützung an dem Gehäuseteil des Brennstoffeinspritzventils möglich. Hierdurch wird eine Dämpfung bei der Betätigung der Düsennadel 9 vermieden.

Der Aktorkörper 3 weist Stirnseiten 26, 27 auf. Die Bereiche 18, 19, 20 des Aktorkörpers 3 liegen zwischen den Stirnseiten 26, 27. Die gesamte Höhe des Aktorkörpers 3 ist hierbei durch die Summe aus der Höhe 18 des Bereichs 18 und der Höhe 19 des Bereichs 19 und der Höhe 20 des Bereichs 20 gegeben. Diese Gesamthöhe ist in der Regel vorgegeben. Um bei der gegebenen Gesamthöhe den maximal möglichen Hub des Aktorkörpers 3 zu optimieren, ist der aktive Bereich 19 möglichst groß vorgegeben. Dies bedeutet andererseits, dass die passiven Bereiche 18, 20 möglichst klein sind. Insbesondere ist die Höhe 18 des Bereichs 18 klein.

Der Aktorkörper 3 weist Enden 28, 29 auf. Hierbei ist die Stirnseite 26 des Endes 28 dem Aktorfuß 4 zugewandt. Die Stirnseite 27 des Endes 29 des Aktorkörpers 3 ist von der Stirnseite 26 abgewandt. Der Aktorkörper 3 liegt mit der Stirnseite 26 des Endes 28 an der Anlagefläche 25 an. Die Einfassung 6 des Aktorfußes 4 umgibt teilweise die Anlagefläche 25. Im montierten Zustand ist somit das Ende 28 des Aktorkörpers 3 von der Einfassung 6 eingefasst. Eine Innengeometrie 30, insbesondere Innenwand 30, der Einfassung 6 ist hierbei an die Ausgestaltung des Aktorkörpers 3, insbesondere der Außenseiten 13 bis 15, angepasst. Insbesondere können abgerundete Kanten 31 der Innengeometrie 30 an die Übergänge zwischen den Außenseiten 13 bis 15 des Aktorkörpers 3 angepasst sein. Hierdurch wird zum einen eine zuverlässige Montage des Aktorkörpers 3 an dem Aktorfuß 4 erzielt. Insbesondere kann eine mittige Zentrierung des Aktorkörpers 3 bezüglich der Längsachse 17 erfolgen. Zum anderen wird nach der Montage und speziell während des Betriebs das Ende 28 des Aktorkörpers 3 von der Einfassung 6 fixiert. Hierdurch ist eine Relativbewegung des Endes 28 des Aktorkörpers 3 bezüglich der Anlagefläche 25 des Übergangsstücks 4 verhindert. Somit besteht auch keine Relativbewegung zwischen der durch die Umspritzung 6 gebildeten Einfassung 6 und dem Aktorkörper 3.

Die Einfassung 6 weist einen Randsteg 32 auf, der in diesem Ausführungsbeispiel Abschnitte 33, 34 umfasst. Somit erstreckt sich der Randsteg 32 abschnittsweise um die Anlagefläche 25. Der Randsteg 32 umschließt hierbei das Ende 28 des Aktorkörpers 3 an der Stirnseite 26, wenn der Aktorkörper 3 an den Aktorfuß 4 montiert ist. Hierdurch ist der Aktorkörper 3 an seinem Ende 28 allseitig auf der Anlagefläche 25 positioniert. Hierbei kann der Aktorkörper 3 an keiner Seite von der Anlagefläche 25 herausgeschoben werden.

Der Randsteg 32 der Einfassung 6 weist eine Höhe 35 auf. Diese Höhe 35 ist vorzugsweise über beide Abschnitte 33, 34 konstant. Die Höhe 35 des Randstegs 32 der Einfassung 6 ist hierbei nicht größer vorgegeben als Höhe 18 des passiven Bereichs 18 des Aktorkörpers 3. Hierdurch umgreift der Randsteg 32 den Aktorkörper 3 an seinem passiven Bereich 18. Speziell wird hierdurch eine Berührung oder ein Einklemmen der Außenelektrode 16 an dem Randsteg 32 vermieden. Da im Betrieb keine Längenänderung des passiven Bereichs 18 auftritt, das heißt, die Höhe 18 konstant ist, kommt es auch zu keiner Reibung zwischen dem Aktorkörper 3 und dem Randsteg 32. Da auch die übrigen Elemente der Einfassung 6 nicht den aktiven Bereich 19 des Aktorkörpers 3 berühren, tritt überhaupt keine Reibung zwischen dem Aktorkörper 3 und der Einfassung 6 im Betrieb auf. Somit wird die Verursachung von Kurzschlüssen zwischen den einzelnen Elektrodenschichten oder eine sonstige Beeinträchtigung von vornherein verhindert. Außerdem wird auch die Wärmeabfuhr aus dem aktiven Bereich 19 durch die Einfassung 6 nicht behindert.

Das piezoelektrische Aktormodul 2 weist eine elektrische Zuleitung 40 auf. Die elektrische Zuleitung 40 endet in elektrischen Kontakten 41, 42, die abschnittsweise aus der Einfassung 6 geführt und abschnittsweise in die Einfassung 6 eingegossen sind. Hierdurch sind die elektrische Kontakte 41, 42 auch gegenüber dem metallischen Grundkörper 5 elektrisch isoliert. Die elektrischen Kontakte 41, 42 können als drahtförmige Kontakte 41, 42, insbesondere Pins 41, 42, ausgestaltet sein. Der elektrische Kontakt 41 ist mit der Außenelektrode 16 elektrisch verbunden. Der weitere elektrische Kontakt 42 ist mit der anderen Außenelektrode elektrisch verbunden. Die Verbindung kann beispielsweise durch Löten ausgestaltet sein.

Da der Aktorkörper 3 an seinem Ende 28 in den Randsteg 32 der Einfassung 6 eingefügt ist, sind die zwischen den Abschnitten 33, 34 des Randstegs 32 angeordneten elektrischen Kontakte 41, 42 in Bezug auf den Aktorkörper 3 und somit auch die Außenelektroden 16, ortsfest angeordnet. Im Betrieb wird dadurch eine Belastung der entsprechenden elektrischen Verbindungen von vornherein verhindert. Hierdurch können die elektrischen Kontaktverbindungen über die Lebensdauer gewährleistet werden.

In diesem Ausführungsbeispiel weist der Randsteg 32 der Einfassung 6 Ausnehmungen 43, 44 auf, die die Abschnitte 33, 34 voneinander trennen. Die elektrischen Kontakte 41, 42 sind hierbei an den Ausnehmungen 43, 44 aus der Einfassung 6 geführt. Dies ermöglicht die Ausbildung einer elektrischen Verbindung, insbesondere Lötverbindung, in einem Bereich der Außenelektrode 16, der sehr nahe an dem passiven Bereich 18 liegt oder an den passiven Bereich 18 angrenzt. Hierdurch wird eine Beeinträchtigung des Dehnungsverhaltens beziehungsweise eine Belastung der elektrischen Verbindungen durch die Dehnung des aktiven Bereichs 19 des Aktorkörpers 3 im Betrieb vermieden.

Bei der Ausgestaltung der Einfassung 6 ist es außerdem vorteilhaft, dass die Größe der Auflagefläche 25 näherungsweise gleich groß ist wie die Größe der Stirnseite 26 des Aktorkörpers 3.

Somit ist eine vorteilhafte Einfassung des Aktorkörpers 3 durch die Umspritzung 6 möglich. Bei dieser bleibt der aktive Bereich 19 beziehungsweise die aktiven Schichten im aktiven Bereich 19 unberührt, wobei auch die Wärmeabfuhr nicht gestört wird. Außerdem wird bei der Montage insbesondere eine mittige Positionierung des Aktorkörpers 3 relativ zu dem Aktorfuß 4 ermöglicht. Eine entsprechende Ausgestaltung kann auch für einen Aktorkopf vorgesehen sein, wobei die elektrischen Kontakte 41, 42 am Aktorkopf natürlich nicht erforderlich sind.

Die Erfindung ist nicht auf die beschriebenen Ausführungsbeispiele beschränkt.

## Patentansprüche

1. Piezoelektrisches Aktormodul (2), insbesondere für Brennstoffeinspritzventile von Brennstoffeinspritzanlagen für Brennkraftmaschinen, mit einem Aktorkörper (3) und zumindest einem Übergangsstück (4), das einen Grundkörper (5) aus einem metallischen Werkstoff und eine Umspritzung (6) aus Kunststoff aufweist, die eine Einfassung (6) für den Aktorkörper (3) bildet, wobei das Übergangsstück (4) eine Anlagefläche (25) aufweist, wobei der Aktorkörper (3) mit einer an einem Ende (28) des Aktorkörpers (3) vorgesehenen Stirnseite (26) an der Anlagefläche (25) des Übergangsstücks (4) anliegt, wobei die Einfassung (6) die Anlagefläche (25) zumindest teilweise umgibt, und wobei die Einfassung (6) den Aktorkörper (3) an seinem Ende (28) allseitig auf der Anlagefläche (25) positioniert, **dadurch gekennzeichnet, dass** die Einfassung (6) einen Randsteg (32) aufweist, der sich zumindest abschnittsweise um die Anlagefläche (25) erstreckt, und dass der Randsteg (32) der Einfassung (6) des Übergangsstücks (4) zumindest eine Ausnehmung (43, 44) aufweist, wobei an der Ausnehmung (43, 44) ein elektrischer Kontakt (41, 42) aus der Einfassung (6) geführt ist und der elektrische Kontakt (41,42) mit einer Außenelektrode (16) des Aktorkörpers (3) verbunden ist.

2. Piezoelektrisches Aktormodul nach Anspruch 1,
**dadurch gekennzeichnet,**
**dass** der Aktorkörper (3) an zumindest einer Außenseite (14) zumindest eine Außenelektrode (16) aufweist, dass der Aktorkörper (3) zwischen der Außenelektrode (16) und der Stirnseite (26) am Ende (28) des Aktorkörpers (3) einen passiven Bereich (18) aufweist und dass der Randsteg (32) der Einfassung (6) den Aktorkörper (3) an seinem passiven Bereich (18) umgreift.

3. Piezoelektrisches Aktormodul nach Anspruch 2,
**dadurch gekennzeichnet,**
**dass** entlang einer Längsachse (17) des Aktorkörpers (3) eine Höhe (35) des Randstegs (32) der Einfassung (6) nicht größer ist als eine Höhe (18) des passiven Bereichs (18) des Aktorkörpers (3).

4. Piezoelektrisches Aktormodul nach einem der Ansprüche 2 oder 3,
**dadurch gekennzeichnet,**
**dass** der Aktorkörper (3) mit seinem Ende (28) in den Randsteg (32) der Einfassung (6) eingefügt ist.

5. Piezoelektrisches Aktormodul nach einem der Ansprüche 1 bis 4,
**dadurch gekennzeichnet,**
**dass** die Größe der Anlagefläche (25) des Übergangsstücks (4) zumindest näherungsweise gleich groß ist wie eine Größe der Stirnseite (26) des Aktorkörpers (3).

6. Piezoelektrisches Aktormodul nach einem der Ansprüche 1 bis 5,
**dadurch gekennzeichnet,**
**dass** die Einfassung (6) an den metallischen Grundkörper (5) angespritzt ist.

7. Piezoelektrisches Aktormodul nach Anspruch 6,
**dadurch gekennzeichnet,**
**dass** das Übergangsstück (4) als Aktorfuß (4) ausgebildet ist und/oder dass ein weiteres Übergangsstück (4) vorgesehen ist, das als Aktorkopf ausgestaltet ist.

8. Brennstoffeinspritzventil (1), insbesondere Injektor für Brennstoffeinspritzanlagen, für luftverdichtende, selbstzündende Brennkraftmaschinen, mit einem piezoelektrischen Aktormodul (2) nach einem der Ansprüche 1 bis 7.

## Claims

1. Piezoelectric actuator module (2), in particular for fuel injection valves of fuel injection systems for internal combustion engines, having an actuator body (3) and having at least one transition piece (4) which has a main body (5) composed of a metallic material and an injection-moulded encapsulation (6) composed of plastic, which injection-moulded encapsulation forms an enclosure (6) for the actuator body (3), wherein the transition piece (4) has an abutment surface (25), wherein the actuator body (3) bears, by way of a face side (26) provided on one end (28) of the actuator body (3), against the abutment surface (25) of the transition piece (4), wherein the enclosure (6) at least partially surrounds the abutment surface (25), and wherein, by means of the enclosure (6), the actuator body (3), at its end (28), is positioned on the abutment surface (25) on all sides, **characterized in that** the enclosure (6) has an edge web (32) which extends at least in sections around the abutment surface (25), and **in that** the edge web (32) of the enclosure (6) of the transition piece (4) has at least one recess (43, 44), wherein an electrical contact (41, 42) is led out of the enclosure (6) at the recess (43, 44), and the electrical contact (41, 42) is connected to an outer electrode (16) of the actuator body (3).

2. Piezoelectric actuator module according to Claim 1,
**characterized**
**in that** the actuator body (3) has at least one outer electrode (16) on at least one outer side (14), in that the actuator body (3) has a passive region (18) between the outer electrode (16) and the face side (26) on the end (28) of the actuator body (3), and in that the edge web (32) of the enclosure (6) engages around the actuator body (3) at its passive region (18).

3. Piezoelectric actuator module according to Claim 2,
**characterized**
**in that**, along a longitudinal axis (17) of the actuator body (3), a height (35) of the edge web (32) of the enclosure (6) is no greater than a height (18) of the passive region (18) of the actuator body (3).

4. Piezoelectric actuator module according to either of Claims 2 and 3,
**characterized**
**in that** the actuator body (3) is infixed by way of its end (28) into the edge web (32) of the enclosure (6).

5. Piezoelectric actuator module according to one of Claims 1 to 4,
**characterized in that** the size of the abutment surface (25) of the transition piece (4) is at least approximately equal to a size of the face side (26) of the actuator body (3).

6. Piezoelectric actuator module according to one of Claims 1 to 5,
**characterized**
**in that** the enclosure (6) is injection-moulded onto the metallic main body (5).

7. Piezoelectric actuator module according to Claim 6,
**characterized**
**in that** the transition piece (4) is in the form of an actuator foot (4), and/or in that a further transition piece (4) is provided which is configured as an actuator head.

8. Fuel injection valve (1), in particular injector for fuel injection systems for air-compressing, autoignition internal combustion engines, having a piezoelectric actuator module (2) according to one of Claims 1 to 7.

## Revendications

1. Module d'actionneur piézo-électrique (2), en particulier pour soupapes d'injection de carburant de systèmes d'injection de carburant pour moteurs à combustion interne, comprenant un corps d'actionneur (3) et au moins une pièce de transition (4) qui comprend un corps de base (5) en un matériau métallique et un surmoulage (6) en plastique qui forme une bordure (6) pour le corps d'actionneur (3), la pièce de transition (4) comprenant une surface d'appui (25), le corps d'actionneur (3) s'appliquant, par un côté frontal (26) prévu à une extrémité (28) du corps d'actionneur (3), contre la surface d'appui (25) de la pièce de transition (4), la bordure (6) entourant au moins partiellement la surface d'appui (25), et la bordure (6) positionnant le corps d'actionneur (3) à son extrémité (28) de tous côtés sur la surface d'appui (25), **caractérisé en ce que** la bordure (6) comprend une nervure de bord (32) qui s'étend au moins en partie autour de la surface d'appui (25), et **en ce que** la nervure de bord (32) de la bordure (6) de la pièce de transition (4) comprend au moins un évidement (43, 44), un contact électrique (41, 42) étant guidé à partir de la bordure (6) au niveau de l'évidement (43, 44) et le contact électrique (41, 42) étant connecté à une électrode extérieure (16) du corps d'actionneur (3).

2. Module d'actionneur piézoélectrique selon la revendication 1,
**caractérisé en ce que**
le corps d'actionneur (3) comprend au moins une électrode extérieure (16) au niveau d'au moins un côté extérieur (14), **en ce que** le corps d'actionneur (3) comprend une région passive (18) entre l'électrode extérieure (16) et le côté frontal (26), à l'extrémité (28) du corps d'actionneur (3), et **en ce que** la nervure de bord (32) de la bordure (6) vient en prise autour du corps d'actionneur (3) au niveau de sa région passive (18).

3. Module d'actionneur piézoélectrique selon la revendication 2,
**caractérisé en ce**
**qu'**une hauteur (35) de la nervure de bord (32) de la bordure (6) le long d'un axe longitudinal (17) du corps d'actionneur (3) n'est pas supérieure à une hauteur (18) de la région passive (18) du corps d'actionneur (3).

4. Module d'actionneur piézoélectrique selon l'une quelconque des revendications 2 ou 3,
**caractérisé en ce que**
le corps d'actionneur (3) est inséré par son extrémité (28) dans la nervure de bord (32) de la bordure (6).

5. Module d'actionneur piézoélectrique selon l'une quelconque des revendications 1 à 4,
**caractérisé en ce que**
la dimension de la surface d'appui (25) de la pièce de transition (4) est au moins approximativement égale à une dimension du côté frontal (26) du corps d'actionneur (3).

6. Module d'actionneur piézoélectrique selon l'une quelconque des revendications 1 à 5,
**caractérisé en ce que**
la bordure (6) est surmoulée sur le corps de base métallique (5).

7. Module d'actionneur piézoélectrique selon la revendication 6,
**caractérisé en ce que**
la pièce de transition (4) est réalisée sous forme de base d'actionneur (4) et/ou **en ce qu'**une pièce de transition supplémentaire (4) est prévue, laquelle est configurée en tant que tête d'actionneur.

8. Soupape d'injection de carburant (1), en particulier injecteur pour systèmes d'injection de carburant, pour moteurs à combustion interne à compression d'air et à autoallumage, comprenant un module d'actionneur piézo-électrique (2) selon l'une quelconque des revendications 1 à 7.
